# EUROPÄISCHE PATENTANMELDUNG

(11) **EP 1 653 788 A1**
(43) Veröffentlichungstag der Anmeldung: **03.05.2006**
(21) Anmeldenummer: 04025670.3
(22) Anmeldetag: 28.10.2004
(51) Int. Cl.: H05K 3/14

(54) **Schattenmaske zur Erzeugung eines elektrisch leitenden Bereiches auf einem dreidimensionalen Schaltungsträger**

(71) Anmelder: Delphi Technologies, Inc., Troy, MI 48007 (US)
(72) Erfinder: Kortwig, Carsten, 42929 Wermeleskirchen (DE); Stier, Martin, 59368 Werne (DE); Cappellini, Christian, 42119 Wuppertal (DE)
(74) Vertreter: Manitz, Finsterwald & Partner GbR

(57) **Zusammenfassung**

Die Erfindung betrifft eine Schattenmaske zur Erzeugung wenigstens eines elektrisch leitenden Bereiches, insbesondere einer Leiterbahn und/oder eines Kontaktpads, mittels eines Spritzverfahrens auf mindestens einem, insbesondere spritzgegossenen, dreidimensionalen Schaltungsträger, wobei die Schattenmaske zumindest eine dem wenigstens einen zu erzeugenden elektrisch leitenden Bereich entsprechende Öffnung umfasst, welche sich von einer dem mindestens einen Schaltungsträger abgewandten Seite der Schattenmaske zu einer dem mindestens einen Schaltungsträger zugewandten Seite der Schattenmaske hin erweitert. Die Erfindung betrifft ferner ein Verfahren und eine Vorrichtung zur Erzeugung wenigstens eines elektrisch leitenden Bereiches auf einem dreidimensionalen Schaltungsträger.

## Beschreibung

Die Erfindung betrifft eine Schattenmaske zur Erzeugung wenigstens eines elektrisch leitenden Bereiches, insbesondere einer Leiterbahn und/oder eines Kontaktpads, mittels eines Spritzverfahrens auf mindestens einem, insbesondere spritzgegossenen, dreidimensionalen Schaltungsträger, wobei die Schattenmaske zumindest eine dem wenigstens einen zu erzeugenden elektrisch leitenden Bereich entsprechende Öffnung aufweist.

Eine derartige Schattenmaske ist grundsätzlich bekannt. Problematisch ist bei dieser, dass sich die Qualität der Strukturübertragung im Verlauf eines oder mehrerer Spritzprozesse verschlechtert.

Der Erfindung liegt die Aufgabe zugrunde, eine Schattenmaske zu schaffen, die eine gleichmäßige und exakte Strukturübertragung dauerhaft ermöglicht.

Zur Lösung der Aufgabe ist eine Schattenmaske mit den Merkmalen des Anspruchs 1 und insbesondere eine Schattenmaske vorgesehen, deren zumindest eine Öffnung sich von einer dem mindestens einen Schaltungsträger abgewandten Seite der Schattenmaske zu einer dem mindestens einen Schaltungsträger zugewandten Seite der Schattenmaske hin erweitert.

Die Erweiterung der Öffnung in Richtung des Schaltungsträgers verhindert, dass sich Teilchen eines auf den Schaltungsträger aufzubringenden und den elektrischen leitenden Bereich bildenden elektrisch leitenden Materials beim Durchgang durch die Öffnung an einer die Öffnung begrenzenden Wand anlagern und dadurch den Querschnitt der Öffnung verringern. Mit anderen Worten verhindert die Erweiterung ein Zuwachsen der Öffnungen während eines Spritzprozesses. Dadurch ist sichergestellt, dass der auf dem Schaltungsträger zu erzeugende elektrisch leitende Bereich stets mit den gewünschten Abmessungen hergestellt wird. Eine exakte Strukturübertragung ist somit dauerhaft gewährleistet.

Darüber hinaus ermöglicht die erfindungsgemäße Erweiterung der Öffnung der Schattenmaske die Erzeugung eines elektrisch leitenden Bereiches mit einer über den gesamten Bereich im Wesentlichen gleichmäßigen Dicke.

Bei herkömmlichen Schattenmasken, deren Öffnungen einen konstanten Öffnungsquerschnitt, d.h. also parallel zueinander verlaufende Wände aufweisen, besteht das Problem, dass beim Aufbringen des elektrisch leitenden Materials sowohl solche Teilchen des Materials, die sich in Richtung des Schaltungsträgers bewegen, als auch solche Teilchen, die von dem Schaltungsträger zurück reflektiert werden, an den Wänden der Öffnung reflektiert werden können.

Eine derartige Reflexion der Teilchen führt dazu, dass die Dicke des elektrisch leitenden Bereiches in einem an die Wand bzw. die Wände der Öffnung angrenzenden Randbereich größer ist als in einem von der Wand bzw. den Wänden der Öffnung entfernten, beispielsweise zentralen Bereich. Im Querschnitt gesehen weist ein so aufgebrachter elektrisch leitender Bereich in seinem Randbereich folglich eine unerwünschte Erhöhung auf.

Durch die erfindungsgemäße Erweiterung der Öffnung der Schattenmaske wird die Reflexion von Teilchen, die sich in Richtung des Schaltungsträgers bewegen, an den Wänden der Öffnung verhindert.

Bei geeigneter Wahl des Erweiterungsgrades der Öffnung, das heißt bei einer geeigneten Wahl des Winkels, den die Wandflächen der Öffnung mit der Oberfläche des Schaltungsträgers bilden, wird darüber hinaus verhindert, dass vom Schaltungsträger zurück reflektierte Teilchen so an den Wänden der Öffnung reflektiert werden, dass sie sich anschließend ausschließlich in einem Randbereich des elektrisch leitenden Bereiches anlagern.

Vielmehr werden die vom Schaltungsträger zurück reflektierten Teilchen durch die Wände der Öffnung der Schattenmaske auch in Richtung einer zentralen Region des elektrisch leitenden Bereiches reflektiert. Auf diese Weise wird durch die erfindungsgemäße Schattenmaske ein elektrisch leitender Bereich mit einer über den gesamten Bereich gleichmäßigen Dicke erzeugt.

Gemäß einer vorteilhaften Ausführungsform der erfindungsgemäßen Schattenmaske entsprechen die Abmessungen der zumindest einen Öff nung an der dem Schaltungsträger zugewandten Seite der Schattenmaske im Wesentlichen den gewünschten Abmessungen des jeweiligen zu erzeugenden elektrisch leitenden Bereiches.

Nicht die zu einer Quelle für das elektrisch leitende Material weisende Seite, d.h. die Eintrittsseite der Öffnung, sondern die dem Schaltungsträger zugewandte Seite, d.h. die Austrittsseite der Öffnung, weist die Strukturgröße des zu erzeugenden elektrisch leitenden Bereiches auf. Dadurch ist sichergestellt, dass der elektrisch leitende Bereich trotz der Erweiterung der Öffnung in der gewünschten Größe, und nicht etwa mit größeren Abmessungen herstellbar ist.

Vorzugsweise ist die zumindest eine Öffnung an der dem Schaltungsträger zugewandten Seite der Schattenmaske um einen Faktor von etwa 1,5 bis 3 größer als an der dem Schaltungsträger abgewandten Seite der Schattenmaske.

Ein Durchmesser der Öffnung kann an der Eintrittsseite beispielsweise 0,3 - 0,5 mm und an der Austrittsseite beispielsweise 0,4 - 0,8 mm aufweisen. Bei einer Stärke der Schattenmaske von 0,3 - 1,5 mm liegt der Winkel, den die Wände der Öffnung mit der Oberfläche des Schaltungsträgers bilden, somit etwa im Bereich von 50° bis 88° und vorzugsweise im Bereich von 60° bis 75°.

Diese Winkelangaben gelten für den Fall, dass es sich bei den Wänden der Öffnung um gerade Schrägflächen handelt, dass die Öffnung also einen im wesentlichen konischen Querschnitt aufweist. Grundsätzlich ist es aber auch möglich, die Wandflächen der Öffnung konvex oder konkav gekrümmt auszubilden.

Besonders vorteilhaft ist es, wenn die Schattenmaske zumindest bereichsweise der Oberflächenkontur des mindestens einen Schaltungsträgers nachgebildet ist. Dadurch kann die Schattenmaske beim Aufbringen des elektrisch leitenden Bereiches so an den Schaltungsträger angelegt werden, dass die Schattenmaske zumindest im Bereich der Öffnung einen minimalen Abstand zum Schaltungsträger aufweist oder besonders bevorzugt mit der Oberfläche des Schaltungsträgers in Kontakt steht. Dies ermöglicht eine besonders exakte Strukturübertragung, mit anderen Worten also eine besonders genaue Herstellung des elektrisch leitenden Bereiches.

Weiterer Gegenstand der Erfindung ist außerdem ein Verfahren mit den Merkmalen des Anspruchs 5. Bei diesem Verfahren zum Erzeugen wenigstens eines elektrisch leitenden Bereiches, insbesondere einer Leiterbahn und/oder eines Kontaktpads, auf mindestens einem, insbesondere spritzgegossenen, dreidimensionalen Schaltungsträger, wird eine Schattenmaske gemäß der voranstehend beschriebenen Art zwischen eine Quelle für ein elektrisch leitendes Material und den mindestens einen Schaltungsträger gebracht und das elektrisch leitende Material durch die Schattenmaske hindurch selektiv auf den mindestens einen Schaltungsträger aufgebracht, insbesondere aufgespritzt.

Bei einem herkömmlichen Verfahren zum Erzeugen von elektrisch leitenden Bereichen auf einem dreidimensionalen Schaltungsträger werden die elektrisch leitenden Bereiche mittels eines Heißprägeverfahrens oder mittels eines Laserverfahrens auf den Schaltungsträger aufgebracht.

Zu diesem Zweck wird der Schaltungsträger mit einer ein Metallmaterial aufweisenden Heißprägefolie bedeckt. Durch Aufdrücken eines Heißprägestempels verbindet sich das Metallmaterial der Heißprägefolie in vorbestimmten Bereichen mit dem Schaltungsträger. Anschließend wird die Heißprägefolie von dem Schaltungsträger abgezogen, wobei das Metallmaterial, welches sich beim Heißprägen mit dem Schaltungsträger verbunden hat, zur Bildung der elektrisch leitenden Bereiche auf dem Schaltungsträger zurückbleibt.

Dieser Prozess ist material- und zeitintensiv und daher kostspielig. Darüber hinaus ist es nur mit einem erhöhten Aufwand möglich, Leiterbahnstrukturen auf schlecht leitende oder auf nicht leitende Materialien, wie z.B. Glas, fest verbunden aufzubringen.

Demgegenüber stellt das erfindungsgemäße Verfahren eine einfache und mit einem geringen wirtschaftlichen Aufwand durchführbare Möglichkeit zur Erzeugung von elektrisch leitenden Bereichen auf dreidimensionalen Schaltungsträgern dar.

Das nicht auf dem Schaltungsträger verwertete elektrisch leitende Material, welches sich während des Prozesses auf der dem Schaltungsträger abgewandten Seite der Schattenmaske anlagert, kann nach dem Prozess leicht entfernt werden und nach einer entsprechenden Wiederaufbereitung dem Spritzprozess erneut zugeführt werden. Dies bedeutet eine erhebliche Material- und somit Kostenersparnis.

Die Verwendung von entsprechend ausgebildeten Schattenmasken ermöglicht außerdem eine gleichzeitige Metallisierung einer Vielzahl von Schaltungsträgern, d.h. eine Beschichtung von großen Nutzen. Dadurch können dreidimensionalen Schaltungsträger noch wirtschaftlicher hergestellt werden.

Wird zur Aufbringung des elektrisch leitenden Materials beispielsweise ein Kaltgas-Spritzverfahren (kinetic spraying) verwendet, so können unterschiedliche elektrisch leitende Materialien, z.B. Metalle wie Gold, Silber, Zinn, Aluminium, etc., auch auf nicht leitenden Materialien haftend und mit den nötigen Schichtdicken aufgetragen werden. Neben einer Erzeugung von elektrisch leitenden Bereichen auf dreidimensionalen Schaltungsträgern aus Kunststoffmaterial, können Leiterstrukturen folglich auch direkt auf eine Fahrzeugfensterscheibe oder auf einen Fahrzeugspiegel, beispielsweise als Antenne oder Heizung, aufgebracht werden.

Wie voranstehend bereits erwähnt wurde, wird durch die Verwendung der erfindungsgemäßen Schattenmaske und insbesondere durch die konische Form der Öffnungen der Schattenmaske erreicht, dass die elektrisch leitenden Bereiche dauerhaft mit einer scharfen Kontur und mit einer gleichmäßigen Dicke herstellbar sind.

Gemäß einer vorteilhaften Ausführungsform des erfindungsgemäßen Verfahrens wird beim Aufbringen des elektrisch leitenden Materials die Schattenmaske mit einem minimalen Abstand von weniger als 1 mm und vorzugsweise von weniger als 0,5 mm zum Schaltungsträger angeordnet.

Ein minimaler Abstand der Schattenmaske zur Oberfläche des Schaltungsträgers trägt dazu bei, dass die durch die Öffnungen der Schattenmaske vorgegebene Struktur exakt auf die elektrisch leitenden Bereiche übertragen wird.

Vorzugsweise wird die Schattenmaske beim Aufbringen des elektrisch leitenden Materials zumindest bereichsweise mit dem Schaltungsträger in Kontakt gebracht.

Dies erleichtert zum einen die Justage der Schattenmaske bezüglich des Schaltungsträgers, indem die Schattenmaske beispielsweise an einem Vorsprung des Schaltungsträgers in Anschlag gebracht werden kann, wodurch sichergestellt ist, dass die elektrisch leitenden Bereiche stets korrekt auf dem Schaltungsträger positioniert sind.

Zum anderen kann der Abstand zwischen der Schattenmaske und dem Schaltungsträger noch weiter verringert werden und die Genauigkeit der Strukturübertragung dadurch noch weiter verbessert werden. Dies gilt insbesondere für den Fall, dass eine plane Schattenmaske verwendet wird.

Besonders bevorzugt ist es, wenn die Schattenmaske beim Aufbringen des elektrisch leitenden Materials im Wesentlichen ganzflächig mit dem Schaltungsträger in Kontakt gebracht wird.

Dies lässt sich insbesondere durch eine Schattenmaske erreichen, welche zumindest bereichsweise der Oberflächenkontur des Schaltungsträgers nachgebildet ist. Auf diese Weise kann die Schattenmaske bevorzugt wenigstens in den Bereichen, in denen die elektrisch leitenden Bereiche erzeugt werden sollen, mit dem Schaltungsträger in Kontakt gebracht werden, so dass der Abstand zwischen der Schattenmaske und dem Schaltungsträger in diesen Bereichen im Wesentlichen Null beträgt.

Dadurch können die elektrisch leitenden Bereiche mit einer noch exakteren Kontur erzeugt werden. Außerdem ermöglicht die Anpassung der Schattenmaske an die Oberflächenkontur des Schaltungsträgers eine noch einfachere und genauere Positionierung der Schattenmaske auf dem Schaltungsträger.

Weiterer Gegenstand der Erfindung ist ferner eine Vorrichtung mit den Merkmalen des Anspruchs 10, die zur Erzeugung wenigstens eines elektrisch leitenden Bereiches, insbesondere einer Leiterbahn und/oder eines Kontaktpads, auf mindestens einem, insbesondere spritzgegossenen, dreidimensionalen Schaltungsträger dient. Die Vorrichtung umfasst eine Quelle für ein auf den Schaltungsträger aufzuspritzendes elektrisch leitendes Material, eine der Quelle gegenüber gelegene Halterung für den mindestens einen Schaltungsträger und eine Schattenmaske gemäß der voranstehend genannten Art, die zwischen die Quelle für das elektrisch leitende Material und den zumindest einen in der Halterung gehaltenen Schaltungsträger bringbar ist, um ein selektives Aufspritzen des elektrisch leitenden Materials durch die Schattenmaske hindurch auf den mindestens einen Schaltungsträger zu ermöglichen.

Mit einer derartigen Vorrichtung lassen sich die voranstehend genannten Vorteile der erfindungsgemäßen Schattenmaske und des erfindungsgemäßen Verfahrens umsetzen.

Nachfolgend wird die Erfindung rein beispielhaft anhand einer vorteilhaften Ausführungsform unter Bezugnahme auf die beigefügte Zeichnung beschrieben. Es zeigen:
- Fig. 1: eine schematische Darstellung der erfindungsgemäßen Vorrichtung und des erfindungsgemäßen Verfahrens;
- Fig. 2: einen Querschnitt durch einen Bereich der in der Vorrichtung und bei dem Verfahren von Fig. 1 verwendeten Schattenmaske;
- Fig. 3: alternative Ausführungsformen der erfindungsgemäßen Schattenmaske;
- Fig. 4: eine Draufsicht auf die in der Vorrichtung und bei dem Verfahren von Fig. 1 verwendeten Schattenmaske;
- Fig. 5: eine Draufsicht auf einen durch das Verfahren von Fig. 1 metallisierten und mit elektronischen Bauelementen bestückten dreidimensionalen Schaltungsträger;
- Fig. 6: eine perspektivische Ansicht des Schaltungsträgers von Fig. 5; und
- Fig. 7: eine Draufsicht auf eine Schattenmaske, die für eine gleichzeitige Metallisierung mehrerer Schaltungsträger vorgesehen ist.

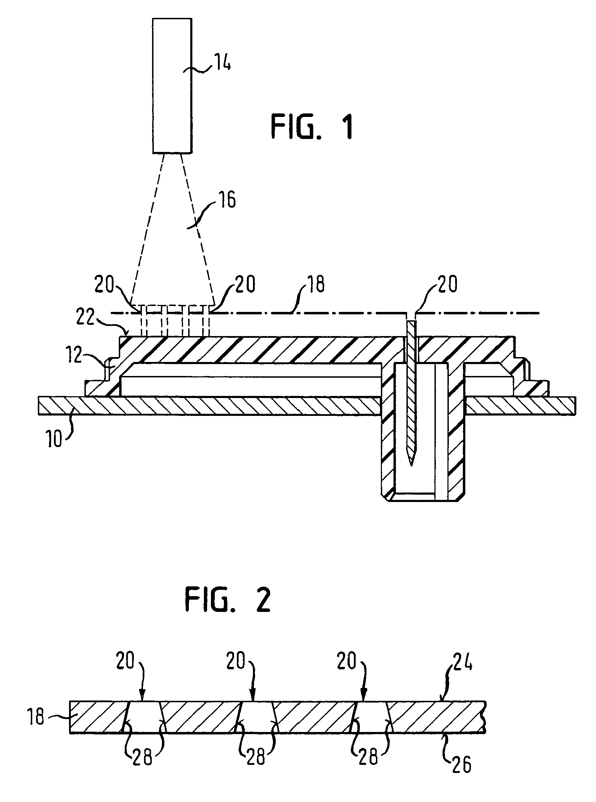

Die in Fig. 1 dargestellte erfindungsgemäße Vorrichtung umfasst eine Halterung 10, auf der ein mit einer elektrischen Leiterstruktur zu versehender dreidimensionaler Schaltungsträger 12 gelagert ist. Bei dem dargestellten Ausführungsbeispiel ist der Schaltungsträger 12 aus einem spritzgegossenen Kunststoffmaterial gebildet, er kann aber auch ein anderes Material umfassen.

Gegenüber, im dargestellten Ausführungsbeispiel oberhalb der Halterung 10 ist eine Quelle 14 für ein elektrisch leitendes Material 16 angeordnet. Im vorliegenden Fall handelt es sich bei der Quelle 14 um eine Kaltgas-Spritzdüse, d.h. das elektrisch leitende Material 16 wird mittels Kaltgasspritzen (kinetic spraying) auf den Schaltungsträger 12 aufgebracht. Denkbar sind aber auch andere geeignete Spritzdüsen. Das elektrisch leitende Material 16 kann z. B. Gold, Silber, Zinn, Aluminium oder Mischungen davon aufweisen.

Zwischen der Quelle 14 und dem in der Halterung 10 gelagerten Schaltungsträger 12 ist eine Schattenmaske 18 angeordnet. Die Schattenmaske 18 ist im vorliegenden Ausführungsbeispiel aus Edelstahl gebildet, sie kann aber auch ein anderes Material aufweisen. Die Stärke der Schattenmaske 18 liegt im Bereich zwischen 0,3 - 1,5 mm.

Im dargestellten Ausführungsbeispiel ist die Schattenmaske 18 zu der Oberfläche 22 des Schaltungsträgers 12 beabstandet angeordnet. Alternativ ist es aber ebenso möglich, die Schattenmaske 18 direkt auf den Schaltungsträger 12 aufzulegen.

Für den Fall, dass die Oberfläche 22 des Schaltungsträgers 12 im Bereich der zu erzeugenden elektrisch leitenden Bereiche dreidimensional ausgebildet ist, empfiehlt es sich, die Schattenmaske 18 ebenfalls dreidimensional und an die Oberflächenkontur des Schaltungsträgers angepasst auszubilden. Eine solche Schattenmaske 18 kann dann direkt an den Schaltungsträger 12 angelegt werden.

Die Schattenmaske 18 weist mehrere Öffnungen 20 auf, um bereichsweise einen Durchgang des von der Quelle 14 ausgestoßenen elektrisch leitenden Materials 16 durch die Schattenmaske 18 hindurch und somit ein selektives Aufbringen des elektrisch leitenden Materials 16 auf die zur Schattenmaske 18 weisenden Oberfläche 22 des Schaltungsträgers 12 zu ermöglichen.

Wie in Fig. 2 gezeigt ist, erweitern sich die Öffnungen 20 von einer zu der Quelle 14 weisenden Seite der Schattenmaske 18, der so genannten Eintrittsseite 24, zu einer dem Schaltungsträger 12 zugewandten Seite der Schattenmaske 18 hin, der so genannten Austrittseite 26. Die Öffnungen 20 weisen somit an der Eintrittsseite 24 geringere Abmessungen als an der Austrittsseite 26 auf.

Die Öffnungen 20 werden bei der in Fig. 2 dargestellten Ausführungsform der Schattenmaske 18 durch schräg zueinander verlaufende gerade Wandflächen 28 begrenzt, so dass die Öffnungen 20 im Querschnitt eine konische Form aufweisen.

Die Größe der Öffnungen 20 richtet sich nach der Art des zu erzeugenden elektrisch leitenden Bereiches, wobei die Öffnungen 20 an der zum Schaltungsträger 12 weisenden Seite der Schattenmaske 18, d.h. an der Austrittsseite 26, gerade derjenigen Größe aufweisen, die der jeweils zu erzeugende elektrisch leitende Bereich haben soll.

Ist der elektrisch leitende Bereich eine Leiterbahn 30, so kann die Breite der entsprechenden Öffnung 20' an der Austrittsseite 26 beispielsweise zwischen 0,4 - 0,8 mm liegen. An der Eintrittsseite 24 der Schattenmaske 18 ist die Öffnung 20' entsprechend kleiner ausgebildet und kann beispielsweise eine Breite von 0,3 - 0,5 mm aufweisen.

Bei einer Stärke der Schattenmaske 18 von 0,3 - 1,5 mm bilden die schrägen Wandflächen 28 mit der Oberfläche 22 des Schaltungsträgers somit einen Winkel, der zwischen 50° und 88° liegt. Mit anderen Worten laufen die Wandflächen 28 ausgehend von der Eintrittseite 24 also unter einem Winkel zwischen 4° und 70° auseinander.

Handelt es sich bei dem elektrisch leitenden Bereich um eine größere Kontaktfläche oder Kontaktpad 32, so weist auch die dazugehörige Öffnung 20" an der Austrittsseite der Schattenmaske 18 eine entsprechende Größe auf. Die schrägen Wandflächen 28 bilden in diesem Fall vorzugsweise den gleichen Winkel mit der Oberfläche 22 des Schaltungsträgers 12 wie voranstehend im Zusammenhang mit der Leiterbahn 30 beschrieben wurde. Es erfolgt also eine entsprechende Aufweitung der Öffnung 20" von der Eintrittsseite 24 hin zur Austrittsseite 26.

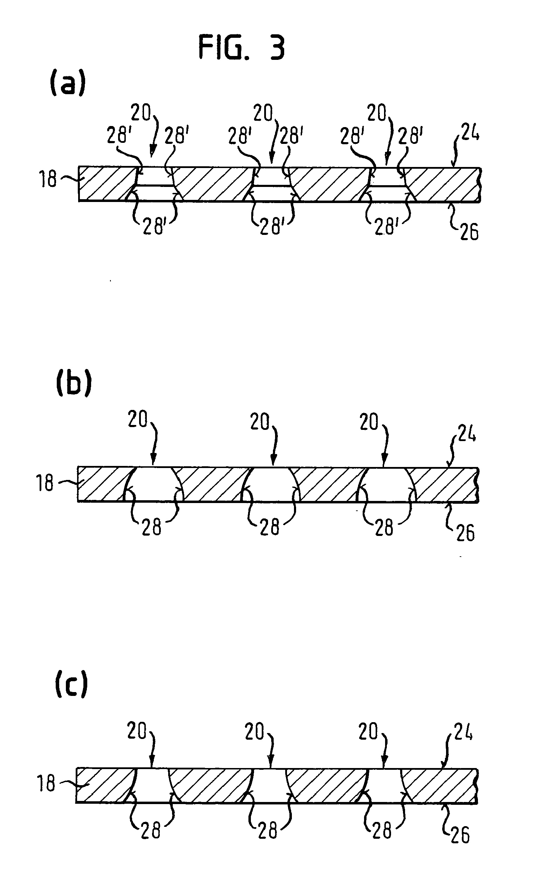

In Fig. 3 sind alternative Ausführungsformen der erfindungsgemäßen Schattenmaske 18 gezeigt. Wie sich aus Fig. 3a ergibt, müssen die die Öffnungen 20 begrenzenden Wandflächen 28 nicht durchgehend gerade sein. Es ist auch möglich, die Wandflächen 28 aus mehreren, beispielsweise zwei, zueinander abgewinkelten Wandflächensegmenten 28' zusammenzusetzen.

Alternativ können die Wandflächen eine gekrümmte Form aufweisen. Dabei können die Wandflächen 28 konkav gekrümmt sein, wie es in Fig. 3b dargestellt ist, oder sie können konvex gekrümmt sein, wie Fig. 3c zeigt.

Selbstverständlich ist es auch denkbar, dass die Wandflächen 28 sowohl gerade als auch gekrümmte Wandflächenabschnitte aufweisen, solange gewährleistet ist, dass der Querschnitt der Öffnungen 20 von der Eintrittsseite 24 gesehen kontinuierlich größer wird.

Ferner müssen nicht alle Öffnungen 20 einer Schattenmaske 18 gleichartige Wandflächenverläufe aufweisen. So ist es beispielsweise vorstellbar, dass eine Sorte von Öffnung 20 gerade, schräge Wandflächen 28 aufweist, wie sie in Fig. 2 gezeigt sind, während eine andere Sorte von Öffnung 20 konkav gekrümmte Wandflächen 28 aufweist, wie sie Fig. 3b zu entnehmen sind.

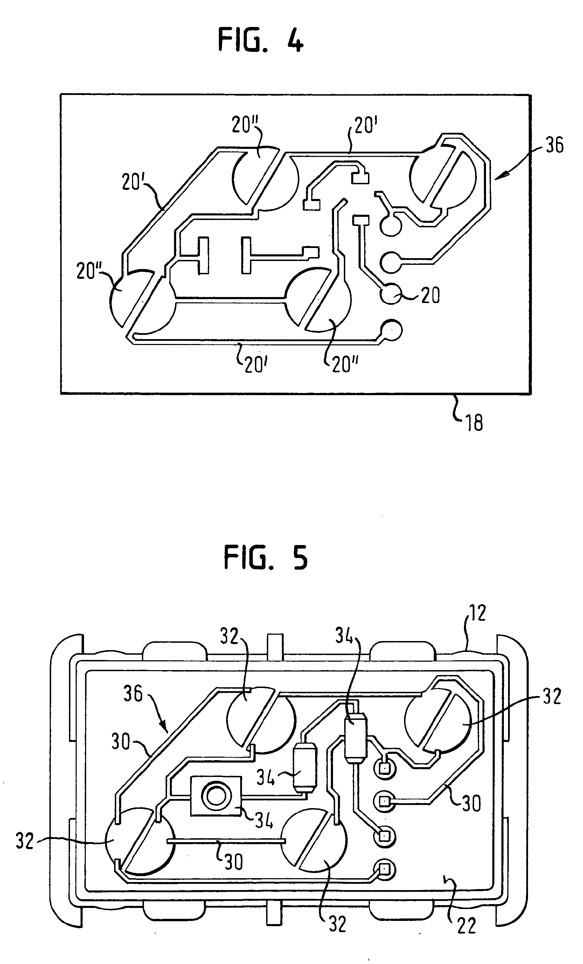

Fig. 4 zeigt eine Draufsicht auf die in Verbindung mit Fig. 1 beschriebene Schattenmaske 18, und Fig. 5 zeigt eine Draufsicht auf den durch diese Schattenmaske 18 entsprechend metallisierten Schaltungsträger 12. Der Zusammenschau der beiden Figuren ist unmittelbar die Übereinstimmung zwischen der Anordnung der Öffnungen 20 der Schattenmaske 18 und der durch die Schattenmaske 18 erzeugten Leiterbahnstruktur 36 auf dem Schaltungsträger 12 zu entnehmen.

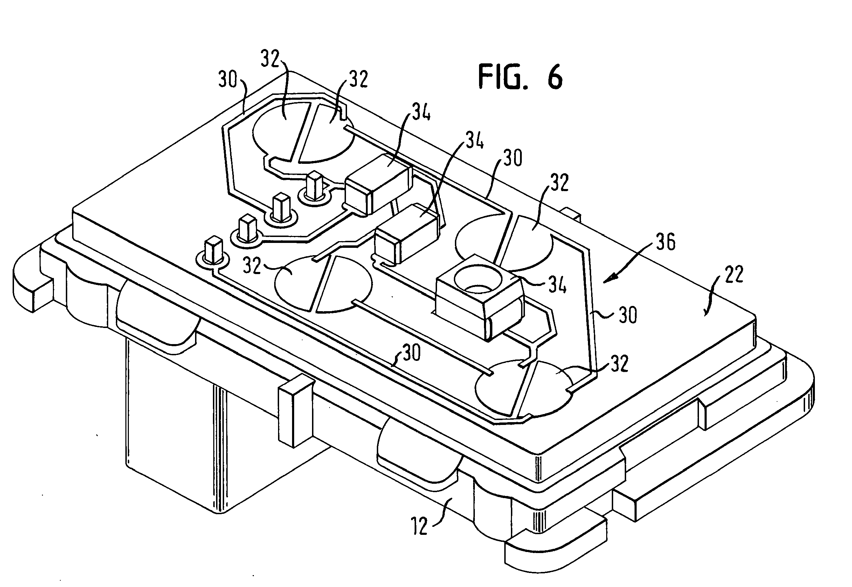

Wie Fig. 5 und 6 ferner zeigen, ist der Schaltungsträger 12 mit elektronischen Bauelementen 34 bestückt, welche durch die aufgespritzten elektrisch leitenden Bereiche 30, 32 elektrisch miteinander verbunden sind.

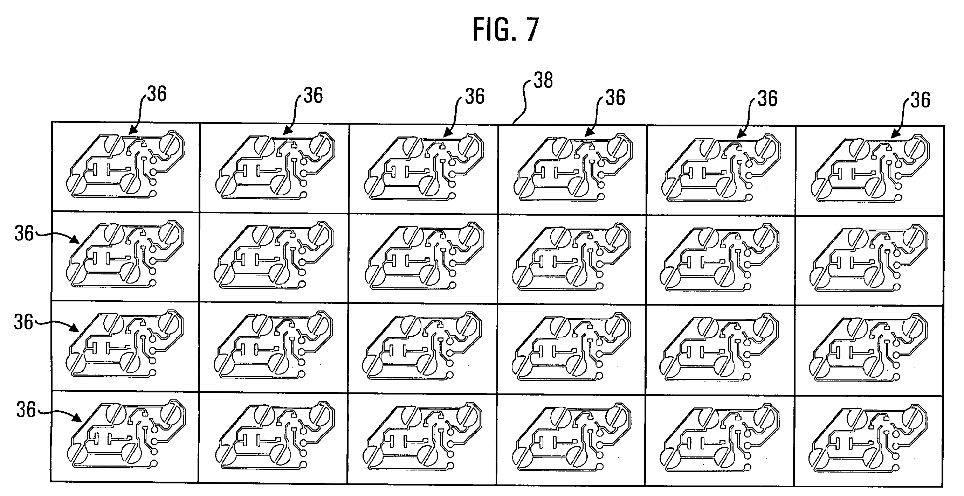

In Fig. 7 ist eine Schattenmaske 38 dargestellt, die 4x6 komplette Leiterstrukturen 36 eines Schaltungsträgers 12 aufweist, welche in einem Array von vier Reihen und sechs Spalten angeordnet sind. Mit Hilfe dieser Schattenmaske 36 lassen sich 24 Schaltungsträger 12 gleichzeitig jeweils mit einer Leiterbahnstruktur 36 versehen. Die Schaltungsträger 12 sind zu diesem Zweck in einer entsprechend ausgebildeten Halterung nebeneinander angeordnet.

Anstelle der hier dargestellten 4x6 Leiterbahnstrukturen 36 kann die Schattenmaske 38 auch eine kleinere oder größere Anzahl von kompletten Leiterbahnstrukturen 36 aufweisen. Außerdem ist es denkbar, dass eine Schattenmaske 38 unterschiedliche Arten von Leiterbahnstrukturen 36 umfasst, so dass sich verschiedene Typen von Schaltungsträgern gleichzeitig metallisieren lassen.

Die Schaltungsträger 12 können somit in großen Nutzen und mit reduziertem wirtschaftlichen Aufwand gefertigt werden.

### Bezugszeichenliste

- 10: Halterung
- 12: Schaltungsträger
- 14: Quelle
- 16: elektrisch leitendes Material
- 18: Schattenmaske
- 20: Öffnung
- 22: Oberfläche
- 24: Eintrittsseite
- 26: Austrittsseite
- 28: Wandfläche
- 30: Leiterbahn
- 32: Kontaktpad
- 34: elektrisches Bauelement
- 36: Leiterbahnstruktur
- 38: Schattenmaske

## Patentansprüche

1. Schattenmaske (18, 38) zur Erzeugung wenigstens eines elektrisch leitenden Bereiches (30, 32), wie insbesondere einer Leiterbahn (30) und/oder eines Kontaktpads (32), mittels eines Spritzverfahrens auf mindestens einem, insbesondere spritzgegossenen, dreidimensionalen Schaltungsträger (12), wobei die Schattenmaske (18, 38) zumindest eine dem wenigstens einen zu erzeugenden elektrisch leitenden Bereich (30, 32) entsprechende Öffnung (20) aufweist, welche sich von einer dem mindestens einen Schaltungsträger (12) abgewandten Seite (24) der Schattenmaske (18, 38) zu einer dem mindestens einen Schaltungsträger (12) zugewandten Seite (26) der Schattenmaske (12) hin erweitert.

2. Schattenmaske nach Anspruch 1,
**dadurch gekennzeichnet, dass**
die Abmessungen der zumindest einen Öffnung (20) an der dem Schaltungsträger zugewandten Seite (26) der Schattenmaske (18, 38) im Wesentlichen den gewünschten Abmessungen des jeweiligen zu erzeugenden elektrisch leitenden Bereiches (30, 32) entspricht.

3. Schattenmaske nach Anspruch 1 oder 2,
**dadurch gekennzeichnet, dass**
die zumindest eine Öffnung (20) an der dem Schaltungsträger (12) zugewandten Seite (26) der Schattenmaske (18, 38) um einen Faktor von etwa 1,5 bis 3 größer ist als an der dem Schaltungsträger (12) abgewandten Seite (24) der Schattenmaske (18, 38).

4. Schattenmaske (18, 38) nach einem der vorherigen Ansprüche,
**dadurch gekennzeichnet, dass**
die Schattenmaske (18, 38) zumindest Bereichesweise der Oberflächenkontur des mindestens einen Schaltungsträgers (12) nachgebildet ist.

5. Verfahren zum Erzeugen wenigstens eines elektrisch leitenden Bereiches (30, 32), insbesondere einer Leiterbahn (30) und/oder eines Kontaktpads (32), auf mindestens einem, insbesondere spritzgegossenen, dreidimensionalen Schaltungsträger (12), bei welchem Verfahren
eine Schattenmaske (18, 38) nach einem der vorherigen Ansprüche zwischen eine Quelle (14) für ein elektrisch leitendes Material (16) und den mindestens einen Schaltungsträger (12) gebracht wird, und
das elektrisch leitende Material (16) durch die Schattenmaske (18, 38) hindurch selektiv auf den mindestens einen Schaltungsträger (12) aufgebracht, insbesondere aufgespritzt wird.

6. Verfahren nach Anspruch 5,
**dadurch gekennzeichnet, dass**
die Schattenmaske (18, 38) beim Aufbringen des elektrisch leitenden Materials (16) mit einem minimalen Abstand von weniger als 1 mm und vorzugsweise von weniger als 0,5 mm zum Schaltungsträger (12) angeordnet wird.

7. Verfahren nach Anspruch 5 oder 6,
**dadurch gekennzeichnet, dass**
die Schattenmaske (18, 38) beim Aufbringen des elektrisch leitenden Materials (16) zumindest Bereichesweise mit dem Schaltungsträger (12) in Kontakt gebracht wird.

8. Verfahren nach einem der Ansprüche 5 bis 7,
**dadurch gekennzeichnet, dass**
die Schattenmaske (18, 38) beim Aufbringen des elektrisch leitenden Materials (16) im Wesentlichen ganzflächig mit dem Schaltungsträger (12) in Kontakt gebracht wird.

9. Verfahren nach einem der Ansprüche 5 bis 8,
**dadurch gekennzeichnet, dass**
das elektrisch leitende Material (16) mittels Kaltgasspritzen auf den mindestens einen Schaltungsträger (12) aufgebracht wird.

10. Vorrichtung zur Erzeugung wenigstens eines elektrisch leitenden Bereiches (30, 32), insbesondere einer Leiterbahn (30) und/oder eines Kontaktpads (32), auf mindestens einen, insbesondere spritzgegossenen, dreidimensionalen Schaltungsträger (12), mit
einer Quelle (14) für ein auf den Schaltungsträger (12) aufzuspritzendes elektrisch leitendes Material (16),
einer der Quelle (14) gegenüber gelegenen Halterung (10) für den mindestens einen Schaltungsträger (12), und
einer Schattenmaske (18, 38) nach einem der Ansprüche 1 bis 4, die zwischen die Quelle (14) für das elektrisch leitende Material (16) und den mindestens einen in der Halterung (10) gehaltenen Schaltungsträger (12) bringbar ist, um ein selektives Aufspritzen des elektrisch leitenden Materials (16) durch die Schattenmaske (18, 38) hindurch auf den mindestens einen Schaltungsträger (12) zu ermöglichen.

## Geänderte Patentansprüche

### Geänderte Patentansprüche gemäss Regel 86(2) EPÜ.

**1.** Verfahren zum Erzeugen wenigstens eines elektrisch leitenden Bereiches (30, 32), insbesondere einer Leiterbahn (30) und/oder eines Kontaktpads (32), auf mindestens einem, insbesondere spritzgegossenen, dreidimensionalen Schaltungsträger (12), bei welchem Verfahren
eine Schattenmaske (18, 38) zwischen eine Quelle (14) für ein elektrisch leitendes Material (16) und den mindestens einen Schaltungsträger (12) gebracht wird, welche zumindest eine dem wenigstens einen zu erzeugenden elektrisch leitenden Bereich (30, 32) entsprechende Öffnung (20) aufweist, die sich von einer dem mindestens einen Schaltungsträger (12) abgewandten Seite (24) der Schattenmaske (18, 38) zu einer dem mindestens einen Schaltungsträger (12) zugewandten Seite (26) der Schattenmaske (12) hin erweitert, und
das elektrisch leitende Material (16) durch die Schattenmaske (18, 38) hindurch selektiv auf den mindestens einen Schaltungsträger (12) aufgespritzt wird.

**2.** Verfahren nach Anspruch 1,
**dadurch gekennzeichnet, dass**
die Schattenmaske (18, 38) beim Aufbringen des elektrisch leitenden Materials (16) mit einem minimalen Abstand von weniger als 1 mm und vorzugsweise von weniger als 0,5 mm zum Schaltungsträger (12) angeordnet wird.

**3.** Verfahren nach Anspruch 1 oder 2,
**dadurch gekennzeichnet, dass**
die Schattenmaske (18, 38) beim Aufbringen des elektrisch leitenden Materials (16) zumindest Bereichesweise mit dem Schaltungsträger (12) in Kontakt gebracht wird.

**4.** Verfahren nach einem der vorherigen Ansprüche,
**dadurch gekennzeichnet, dass**
die Schattenmaske (18, 38) beim Aufbringen des elektrisch leitenden Materials (16) im Wesentlichen ganzflächig mit dem Schaltungsträger (12) in Kontakt gebracht wird.

**5.** Verfahren nach einem der vorherigen Ansprüche,
**dadurch gekennzeichnet, dass**
das elektrisch leitende Material (16) mittels Kaltgasspritzen auf den mindestens einen Schaltungsträger (12) aufgebracht wird.

**6.** Verfahren nach einem der vorherigen Ansprüche,
**dadurch gekennzeichnet, dass**
die Abmessungen der zumindest einen Öffnung (20) an der dem Schaltungsträger zugewandten Seite (26) der Schattenmaske (18, 38) im Wesentlichen den gewünschten Abmessungen des jeweiligen zu erzeugenden elektrisch leitenden Bereiches (30, 32) entspricht.

**7.** Verfahren nach einem der vorherigen Ansprüche,
**dadurch gekennzeichnet, dass**
die zumindest eine Öffnung (20) an der dem Schaltungsträger (12) zugewandten Seite (26) der Schattenmaske (18, 38) um einen Faktor von etwa 1,5 bis 3 größer ist als an der dem Schaltungsträger (12) abgewandten Seite (24) der Schattenmaske (18, 38).

**8.** Verfahren nach einem der vorherigen Ansprüche,
**dadurch gekennzeichnet, dass**
die Schattenmaske (18, 38) zumindest Bereichesweise der Oberflächenkontur des mindestens einen Schaltungsträgers (12) nachgebildet ist.

**9.** Vorrichtung zur Erzeugung wenigstens eines elektrisch leitenden Bereiches (30, 32), insbesondere einer Leiterbahn (30) und/oder eines Kontaktpads (32), auf mindestens einen, insbesondere spritzgegossenen, dreidimensionalen Schaltungsträger (12), mit
einer Quelle (14) für ein auf den Schaltungsträger (12) aufzuspritzendes elektrisch leitendes Material (16),
einer der Quelle (14) gegenüber gelegenen Halterung (10) für den mindestens einen Schaltungsträger (12), und
einer Schattenmaske (18, 38), die zumindest eine dem wenigstens einen zu erzeugenden elektrisch leitenden Bereich (30, 32) entsprechende Öffnung (20) aufweist, welche sich von einer dem mindestens einen Schaltungsträger (12) abgewandten Seite (24) der Schattenmaske (18, 38) zu einer dem mindestens einen Schaltungsträger (12) zugewandten Seite (26) der Schattenmaske (12) hin erweitert, und die zwischen die Quelle (14) für das elektrisch leitende Material (16) und den mindestens einen in der Halterung (10) gehaltenen Schaltungsträger (12) bringbar ist, um ein selektives Aufspritzen des elektrisch leitenden Materials (16) durch die Schattenmaske (18, 38) hindurch auf den mindestens einen Schaltungsträger (12) zu ermöglichen.

**10.** Vorrichtung nach Anspruch 9,
**dadurch gekennzeichnet, dass**
die Abmessungen der zumindest einen Öffnung (20) an der dem Schaltungsträger zugewandten Seite (26) der Schattenmaske (18, 38) im Wesentlichen den gewünschten Abmessungen des jeweiligen zu erzeugenden elektrisch leitenden Bereiches (30, 32) entspricht.

**11.** Vorrichtung nach Anspruch 9 oder 10,
**dadurch gekennzeichnet, dass**
die zumindest eine Öffnung (20) an der dem Schaltungsträger (12) zugewandten Seite (26) der Schattenmaske (18, 38) um einen Faktor von etwa 1,5 bis 3 größer ist als an der dem Schaltungsträger (12) abgewandten Seite (24) der Schattenmaske (18, 38).

**12.** Vorrichtung nach einem der Ansprüche 9 bis 11,
**dadurch gekennzeichnet, dass**
die Schattenmaske (18, 38) zumindest Bereichesweise der Oberflächenkontur des mindestens einen Schaltungsträgers (12) nachgebildet ist.
